# EUROPEAN PATENT APPLICATION

(11) **EP 4 525 570 A1**
(43) Date of publication of application: **19.03.2025**
(21) Application number: 23197764.6
(22) Date of filing: 15.09.2023
(51) Int. Cl.: H05K 7/14

(54) **MOUNTING ARRANGEMENT FOR AN ELECTRONIC COMPONENT**

(71) Applicant: TE Connectivity India Private Limited, Bangalore, Karnataka 560066 (IN); TE Connectivity Belgium B.V., 8020 Oostkamp (BE); TE Connectivity Solutions GmbH, 8200 Schaffhausen (CH)
(72) Inventor: SHOBINTH, Nikshep Kargadde, 560066 Bangalore (IN); SINGH, Kiranpal, 560066 Bangalore (IN); OCKET, Tom, 8020 Oostkamp (BE); FAAS, Sven, 8200 Schaffhausen (CH)
(74) Representative: Grünecker Patent- und Rechtsanwälte PartG mbB

(57) **Abstract**

The invention relates to a mounting arrangement (1) for holding an electronic component, comprising a housing (2) having a housing base (8) and a housing cover (10) configured to be mounted onto the housing base, a receptacle (4) for accommodating an electronic component (12), such as a PCB (14), between the housing base and the mounted housing cover, and at least one component fixation member (6) which is elastically deformable and configured to be located in the receptacle for fixating the electronic component in the receptacle. A mounting arrangement according to the invention is easy to assemble, inexpensive and capable of securely holding an electronic component.

## Description

The invention relates to a mounting arrangement for holding an electronic component, such as a PCB.

Electronic devices, such as sensors, may consist of or comprise an electronic component e.g. for signal processing, which is mounted on a PCB. In order to ensure the functionality of the device, it must be assured that the electronic component of the electronic device is safely held in place, in particular in environments where shocks and vibrations may act on the device.

The structure and assembly of such devices and components should be as simple as possible, as low production and assembly costs are generally desirable.

It is therefore an object of the invention to provide a mounting arrangement that is easy to assemble, inexpensive, and capable of securely holding an electronic component.

This object is solved by a mounting arrangement for holding an electronic component, comprising a housing having a housing base and a housing cover configured to be mounted onto the housing base, a receptacle for accommodating an electronic component, such as a PCB, between the housing base and the mounted housing cover, and at least one component fixation member which is elastically deformable and configured to be located in the receptacle for fixating the electronic component in the receptacle.

Such a mounting arrangement makes it possible to securely fixate an electronic component, without the mounting arrangement requiring a complex design or an elaborate assembly process. Only a few components are required, which reduces the design effort, the assembly effort and the production costs. Furthermore, the holding force exerted on the electronic component by the component fixation member can be flexibly adjusted depending on the use case. Since the component fixation member is elastically deformable, the holding force depends on the extent of the deformation of the component fixation member. A certain extent of deformation, and thus a specific holding force can be achieved, for example, by a suitable selection or positioning of the component fixation member in the receptacle.

The above invention may be further improved by adding one or more of the features described in the following, whereby each of these features is advantageous in itself, and may be combined independently and/or in any desired manner with any of the other features described herein.

The component fixation member may be configured to press the electronic component that is accommodated in the receptacle, along a pressing direction. The pressing direction may extend along a normal direction of the electronic component, in particular perpendicular to the place of the PCB, and/or the receptacle and/or the housing base and/or the housing cover. In some embodiments, a force may be exerted on the housing base and/or the housing cover along the pressing direction in order to elastically deform the at least one component fixation member and/or to maintain the deflection of the at least one component fixation member.

Further, a restoring force of a component fixation member may press the electronic component against the housing base or against the housing cover. The restoring force may act along the pressing direction with at least one directional component, and/or along the direction in which a component fixation member is deformable and/or deformed. In particular, the restoring force may counteract a deformation direction.

In some embodiments, a component fixation member may also be elastically compressible and/or deflectable, advantageously along the pressing direction.

The housing base and the housing cover may be fixedly attachable and/or attached to each other. When the housing cover is mounted onto the housing base, relative movement between the housing base and the housing cover may be prevented, in particular movement along the pressing direction. A component fixation member may be braced and/or clamped between the housing base and the housing cover opposite to its direction of action. The direction of action of a component fixation member may extend along the direction of the restoring force. An elastically deformed component fixation member may push or tend to push the housing base and the housing cover apart from each other, in particular along the direction of the restoring force and/or the direction of action of the component fixation member. In case more than one component fixation member is provided, at least two of the component fixation members used may differ in the direction of their restoring force and/or their direction of action. It is further possible that all component fixation members have the same direction of the restoring force or the same direction of action.

The receptacle, in particular an inner volume of the receptacle, even more particular a contour of the inner volume of the receptacle may be at least sectionally complementary to a volume, an outline or a contour of the electronic component. The electronic component may completely fill the receptacle. In particular, the electronic component, an outline of the electronic component, or a contour of the electronic component may abut the housing base and/or the housing cover. The electronic component may further abut or contact a component fixation member, at least sectionally.

The housing base and/or the housing cover may be part of or completely form a sensor housing. The housing base may be - advantageously monolithically formed - made of a plastic material, and the housing cover may be made of a weldable metallic or plastic material. The housing cover may be monolithically formed.

In one embodiment, the housing base and/or the housing cover may be provided with contact surfaces configured for making contact with the electronic component. The contact surfaces may comprise an electronically conductive or an insulating material.

According to another embodiment, a component fixation member may be monolithically formed with the housing base. This way, the manufacturing costs of the housing base and thus of the mounting arrangement are reduced, in particular due to an automated production. The component fixation member may be integrally and/or materially formed with or joined to the housing base. For example, the component fixation member may be welded, in particular laser-welded with the housing base.

To reduce the production costs of the housing cover, in particular due to an automated production, and thus to lower the total costs of a mounting arrangement, a component fixation member may be monolithically formed with the housing cover. In analogy to the embodiment described above, a component fixation member may be integrally and/or materially formed with or joined to the housing cover. The component fixation member may be welded, particularly laser-welded with the housing cover.

According to a further embodiment, a component fixation member may be formed as a spring latch protruding at least partially towards the receptacle. A spring latch has a simple design and is therefore easy and inexpensive to manufacture.

A component fixation member, e.g. formed as a spring latch, may protrude from the housing base or the housing cover. A component fixation member that protrudes from the housing base may protrude towards the housing cover, and a component fixation member that protrudes from the housing cover may protrude towards the housing base. The spring latch, and additionally or cumulatively another component fixation member, may - regardless of whether it protrudes from the housing base or the housing cover- extend towards the electronic component.

The spring latch, in particular a longitudinal axis of the spring latch and/or a plane of the spring latch, may be oriented in an angle to the pressing direction. The angle may, for example, be acute or obtuse.

In one embodiment, the spring latch may have a base and a free end. The base may be configured to be joined with the housing base or the housing cover. In particular, the base of the spring latch may be monolithically and/or integrally and/or materially formed with the housing base or the housing cover. The free end of the spring latch may be adapted to contact the electronic component, and may comprise an electronically conductive or insulating material. In particular, the spring latch may be completely formed from such material.

In one embodiment, the thickness of the spring latch may be smaller than 1 mm.

According to another embodiment, a component fixation member may comprise a convex section protruding towards the receptacle. If such a component fixation member is elastically deformed, the tension is evenly distributed at the convex section, which results in a lower stress on the material and thus longer durability of the component fixation member.

An apex of the convex section may protrude towards the receptacle. The apex may face in the direction of the receptacle and/or in the pressing direction.

The convex section may have a rotary paraboloid shape that is rotationally symmetrical. The convex section may further be separated into segments, which may be arranged symmetrically, e.g. with respect to the normal direction extending from the apex of the convex section and/or with respect to the pressing direction. During deformation, the convex section may change - in particular flatten - its shape to a rotary paraboloid. In one embodiment, the deformed convex section may be completely flat, so that the contour of the deformed convex section fits into the contour of the housing cover of the housing base, in particular seamlessly and/or without a rounded transition.

A component fixation member may comprise multiple convex sections that may be arranged symmetrically, e.g. with respect to a common axis. The common axis may extend along the pressing direction.

In one embodiment, a component fixation member or the convex section of a component fixation member may be a plate spring.

To reduce the manufacturing costs and the assembly effort, a component fixation member may be an O-ring. The O-ring may be deformable along the pressing direction and/or along the axial direction of the O-ring. Both a toroidal and a hollow cylindrical design of the O-ring are possible. In one embodiment, the O-ring may be a sealing ring.

According to another embodiment, the mounting arrangement may comprise at least one component fixation member of the group of component fixation members comprising:
- a spring latch;
- a spring latch being monolithically formed with the housing base;
- a spring latch being monolithically formed with the housing cover;
- a component fixation member comprising a convex section;
- a component fixation member comprising a convex section, the component fixation member being monolithically formed with the housing base;
- a component fixation member comprising a convex section, the component fixation member being monolithically formed with the housing cover;
- an O-ring.

Due to the variety of different component fixation members, the electronic component can be fixated redundantly and thus particularly securely in the receptacle of the mounting arrangement.

If more than one component fixation member is provided in the mounting arrangement, at least two component fixation members may be designed differently from one another. In particular, all component fixation members may differ in what kind of element is used as component fixation member. If more than one component fixation member is provided, at least one component fixation member may, for example, be designed as a spring latch. At the same time, at least one component fixation member not designed as spring latch may be an O-ring, and at least one component fixation member that is not designed as a spring latch or an O-ring can have at least one convex section. Of course, other types of elements that a component fixation member can be designed as are also possible.

All component fixation members may be designed as the same type of element. For example, all component fixation members may be designed as a spring latch, or all component fixation members may be designed as an O-ring, or all component fixation members may be designed with at least one convex section, or all component fixation members may be designed in accordance with another embodiment.

It is further conceivable that a component fixation member of a certain embodiment is not provided at all. For example, at least one component fixation member may be a spring latch, another component fixation member may be an O-ring, but no component fixation member may comprise a convex section. Furthermore, it is also possible that only a single component fixation member is provided, which may be designed either as a spring latch, as an O-ring, with at least one convex section, or in accordance with another embodiment.

Regardless of whether a component fixation member is a spring latch, an O-ring, comprises a convex section, or is designed according to another embodiment, it may be monolithically formed with the housing base or the housing cover. However, not every component fixation member must be connected to the housing base or the housing cover, let alone monolithically. A component fixation member may be separate from the housing base and the housing cover, i.e. it is neither joined with the housing base nor with the housing cover.

According to another embodiment, the housing base and/or the housing cover may comprise at least one engagement protrusion at least partially penetrating the receptacle. Such an engagement protrusion enables the housing base and/or the housing cover to engage with other components of the mounting arrangement, so that the housing base and/or the housing cover can be aligned relative to such components.

The at least one engagement protrusion may penetrate and/or protrude into the receptacle along the pressing direction. In one embodiment, an engagement protrusion may be formed as a collar protruding from the housing base or the housing cover, preferably perpendicularly.

The electronic component may comprise at least one engagement hole complementary to the at least one engagement protrusion of the housing base and/or the housing cover. An engagement hole may be located in the center of the electronic component and may at least partially penetrate the electronic component. In one embodiment, an engagement hole may be a through-hole.

The at least one engagement protrusion and the at least one engagement hole may be engaged to prevent a shearing movement between the electronic component and the housing base and/or between the electronic component and the housing cover. In particular, movement perpendicular to the longitudinal axis of the engagement hole may be prevented.

To join the housing base and the housing cover with high accuracy and with low material stress, the housing base and the housing cover may be joined by laser-welding in at least one welding section. At least one welding section may be circular or may be formed as a single point. In one embodiment, all welding sections are circular or formed as a single point.

According to another embodiment, a welding section may be located at an engagement protrusion. The welding section may be positioned at an end face of the engagement protrusion facing towards or protruding into the receptacle. The engagement protrusion of this embodiment serves at least two functions simultaneously, namely, to align multiple components of the mounting arrangement relative to each other, and to materially join the housing base to the housing cover. This functional integration reduces production costs.

In another aspect, the housing base may comprise a collar surrounding the receptacle, and a sealing element may be provided, the sealing element extending around an outer side of the collar, the outer side facing away from the receptacle. Such a collar enables the mounting arrangement to be mated and aligned with a housing arrangement being formed at least partially complementary to the collar.

The collar, in particular a wall of the collar, may be cylindrical or cuboid. The collar or a longitudinal axis of the collar, respectively, may extend along the pressing direction. The sealing element may be a ring such as an O-ring, or may be formed as a sealing block or a sealing strip. In one embodiment, the sealing element may extend along an inner side of the collar, the inner side facing towards the receptacle.

According to a further embodiment, the housing cover may comprise at least one holder adapted for holding the sealing element in position, wherein the at least one holder surpasses the collar perpendicular to the pressing direction. The holder ensures that the sealing element is fixed to the housing base so that the sealing element cannot be lost, which simplifies the assembly of the mounting arrangement. The sealing element may be prevented from moving along the longitudinal axis of the collar and from falling off the collar. Thereby, the sealing element is secure against loss.

A holder may extend from an inner side to an outer side of the collar, the inner side of the collar facing towards the receptacle and the outer side of the collar facing away from the receptacle. A holder may extend around an end face of the collar facing away from the receptacle. Therefore, a holder may comprise a U-shaped, L-shaped, or hook-shaped section. A holder may remain joined with the housing base after the mounting arrangement has been mated with a complimentary housing arrangement. Alternatively or cumulatively, a holder may at least be partially removed from the mounting arrangement.

If more than one holder is provided, at least some of the holders may be arranged symmetrically, e.g. to the longitudinal axis of the collar and/or to the pressing direction.

To lower the manufacturing costs, in particular due to an automated production, a holder may be monolithically formed with the housing cover. In some embodiments, multiple or all holders are monolithically formed with the housing cover. A holder may be welded to the housing cover or otherwise integrally or materially formed with or joined to the housing cover. Laser welding may be used as welding technology.

According to another aspect, the housing may comprise at least one mounting flange, via which the mounting arrangement is connectable to another device. This offers the advantage that the mounting arrangement can be securely and firmly connected to other devices. The device may correspond to a housing or a housing arrangement, e.g. being part of a sensor. The mounting flange may be provided with a through-hole adapted for engaging a fastening means and/or a complementary projection of a housing or housing arrangement. The through-hole of the mounting flange may be threaded.

In the following, the invention is explained exemplarily in more detail with reference to the drawings and in accordance with several embodiments, the different features of which can be combined with one another as desired in accordance with the above general description. Moreover, a feature may be omitted from the below embodiments if its technical effect is not required in a particular application. Likewise, a feature described above that is not present in an embodiment as described below may be added if its technical effect is essential for a particular application.

In the following, the same reference numerals are used for elements that correspond to each other with respect to at least one of structure and function.

Shown are:
- Fig. 1: a schematic sectional view of a mounting arrangement according to a possible embodiment, the component fixation member being a spring latch;
- Fig. 2: a schematic sectional view of a mounting arrangement according to another possible embodiment, the component fixation member having convex sections;
- Fig. 3: a schematic sectional view of a mounting arrangement according to a further possible embodiment, one component fixation member being an O-ring;
- Fig. 4: a schematic sectional view of a mounting arrangement according to a another possible embodiment, comprising a sealing element and a holder;
- Fig. 5: a schematic sectional view of a mounting arrangement according to yet another possible embodiment, further comprising mounting flanges;
- Fig. 6: a schematic sectional view of a mounting arrangement according to a further possible embodiment, being assembled with a device.

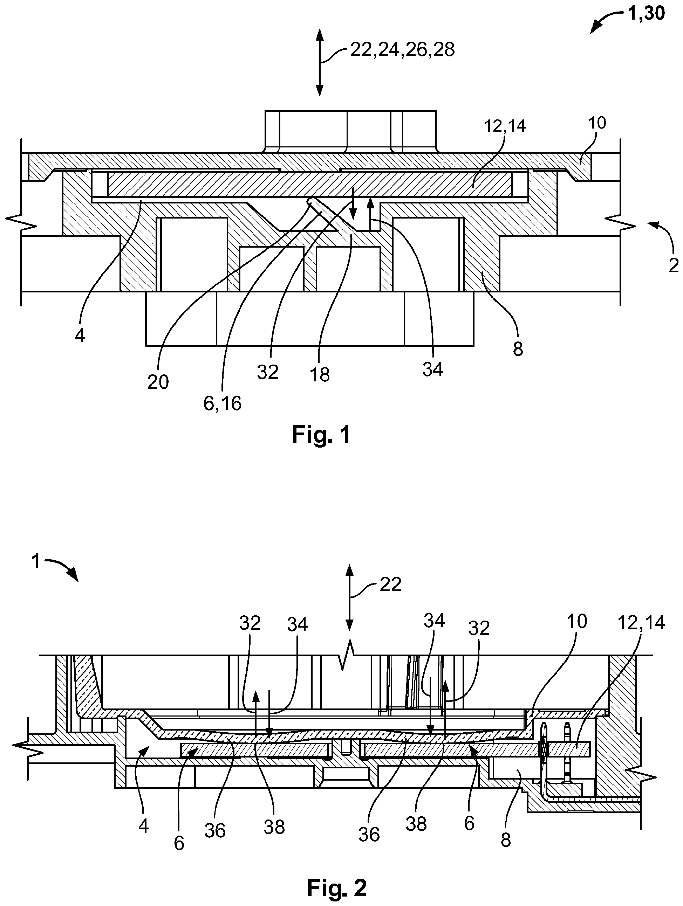

In the following, the structure and functionality of the mounting arrangement according to several embodiments is described with reference to Fig. 1 to Fig. 6.

As seen in Fig. 1, the mounting arrangement 1 comprises a housing 2, a receptacle 4, and at least one component fixation member 6. The housing 2 comprises a housing base 8 and a housing cover 10. The housing cover 10 is mounted onto the housing base 8, such that they are fixedly attached to each other. The receptacle 4 is located between the housing base 8 and the housing cover 10 and is configured to accommodate an electronic component 12. In the embodiment shown in Fig. 1, the receptacle 4 is substantially cuboid. The electronic component 12, which in this embodiment is a PCB 14, is received in the receptacle 4, such that the PCB 14 is enclosed by the housing base 8 and the housing cover 10.

The component fixation member 6 is elastically deformable and configured to be located in the receptacle 4. In the embodiment of Fig. 1, a component fixation member 6 is exemplary formed as a spring latch 16. The spring latch 16 may be formed monolithically with the housing base 8 and may protrude towards the receptacle 4. In the shown embodiment, the spring latch 16 comprises a base 18 and a free end 20. The base of the spring latch 16 may be monolithically formed with the housing base 8, and the free end 20 of the spring latch 16 contacts the PCB 14. The spring latch 16 is elastically deflectable along a pressing direction 22, which in the shown embodiment extends along the normal direction 24 of the housing base 8, the normal direction 26 of the PCB 14 and the normal direction 28 of the housing cover 10.

The mounting arrangement 1 shown in Fig. 1 is in a mounted state 30. The PCB 14 is received in the receptacle 4 between the housing base 8 and the housing cover 10 and the spring latch 16 is elastically deflected along a direction of deflection 32. In the shown embodiment, the direction of deflection 32 extends along the pressing direction 22. The elastically deflected spring latch 16 exerts a restoring force 34, which acts opposite to the direction of deflection 32. As the spring latch 16, in particular the free end 20 of the spring latch 16, abuts the PCB 14, the restoring force 34 of the spring latch 16 is exerted on the PCB 14. As the housing base 8 and the housing cover 10 are fixedly connected to each other, relative movement between the housing base 8 and the housing cover 10 is prevented. In particular, movement is prevented along the pressing direction 22. Thus, the housing cover 10 cannot escape the restoring force 34 of the spring latch 16, which is why the PCB 14 is pushed against the housing cover 10. The PCB 14 is clamped between the housing base 8 and the housing cover 10 and the PCB 14 is securely fixated in the receptacle 4 of the mounting arrangement 1.

According to another embodiment, a component fixation member 6 may comprise a convex section 36. As shown in Fig. 2, the component fixation member 6 may comprise two convex sections 36, which may be monolithically formed with the housing cover 10. Each convex section 36 comprises an apex 38 that faces towards and/or protrudes into the receptacle 4. The convex sections 36, in particular the apexes 38, are in contact with the PCB 14. The mounting arrangement 1 shown in Fig. 2 is in the mounted state 30. The PCB 14 is accommodated in the receptacle 4 between the housing base 8 and the housing cover 10 and the convex sections 36 are elastically deformed along the direction of deflection 32 extending along the pressing direction 22. In analogy to the functionality of the mounting arrangement 1 according to the embodiment shown in Fig. 1, the elastically deformed convex sections 36 exert the restoring force 34, which counteracts the direction of deflection 32. As a consequence, the PCB 14 is pressed towards the housing base 8 and thus clamped between the housing cover 10 and the housing base 8, such that the PCB 14 is securely fixated in the receptacle 4.

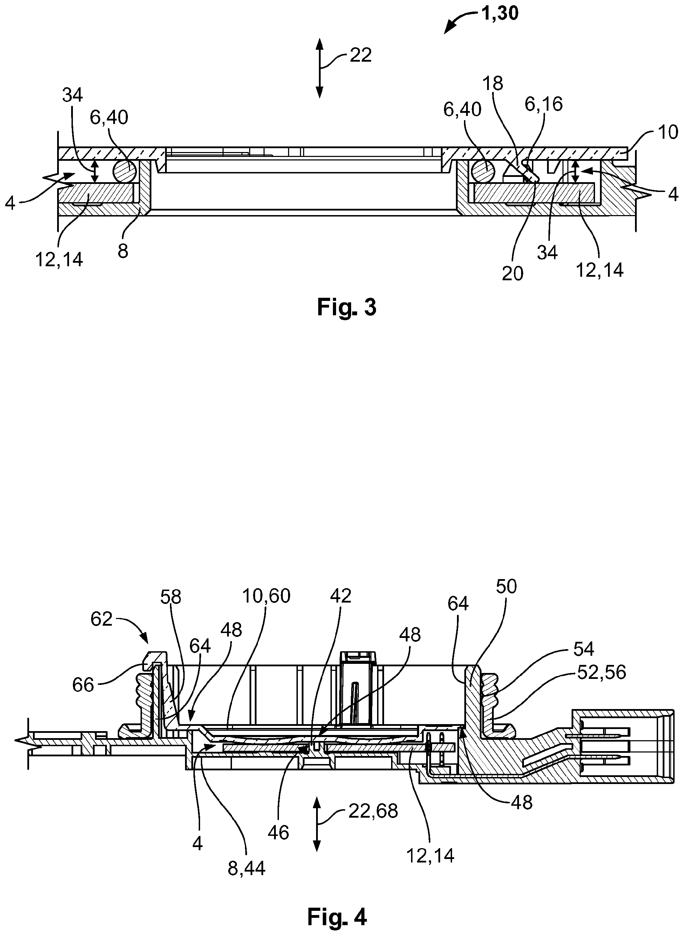

As shown in the embodiment of Fig. 3, a component fixation member 6 may be an O-ring 40. The O-ring 40 may be located in the receptacle 4, in particular between the housing cover 10 and the PCB 14, such that the O-ring 40 abuts the housing cover 10 and the PCB 14. In the mounted state 30, the O-ring 40 is elastically deformed or compressed between the housing cover 10 and the PCB 14. The deformation or compression of the O-ring 40 causes the restoring force 34 that tends to push the housing cover 10 and the PCB 14 apart, in particular along the pressing direction 22. As the PCB 14 abuts the housing base 8 and the housing cover 10, and because the housing base 8 and the housing cover 10 are fixedly attached to each other, the PCB 14 is pressed against the housing base 8. The PCB 14 is thereby fixated in the receptacle 4, as the PCB 14 is clamped between the housing base 8 and the elastically deflected O-ring 40.

In another embodiment, the mounting arrangement 1 may comprise more than one component fixation member 6. The component fixation members 6 may each be designed differently. As further shown in Fig. 3, the mounting arrangement 1 may comprise, in addition to the O-ring 40, another component fixation member 6 that may be designed as a spring latch 16. In the shown embodiment, the spring latch 16 protrudes from the housing cover 10 and into the receptacle 4. In particular, the base 18 of the spring latch 16 may be monolithically formed with the housing cover 10 and the free end 20 of the spring latch 16 may abut the PCB 14. The functionality of the spring latch 16 is similar to the functionality of the spring latch 16 described before with reference to Fig. 1. In the mounted state 30, the spring latch 16 pushes the PCB 14 against the housing base 8. Both component fixation members 6 shown in Fig. 3, namely the spring latch 16 and the O-ring 40, thus push the PCB 14 against the housing base 8, whereby the PCB 14 is fixated in the receptacle 4 of the mounting arrangement 1.

According to another embodiment, the housing base 8 and/or the housing cover 10 may comprise at least one engagement protrusion 42. In the embodiment shown in Fig. 4, the housing base 8 is provided with an engagement protrusion 42. The engagement protrusion 42 may protrude perpendicular to a flat portion 44 of the housing base 8 and into the receptacle 4. In particular, the engagement protrusion 42 of the housing base 8 may penetrate a through-hole 46 in the PCB 14, the through-hole 46 being complementary to the engagement protrusion 42 of the housing base 8. When the engagement protrusion 42 of the housing base 8 and the through-hole 46 of the PCB 14 are engaged, relative movement perpendicular to the engagement protrusion 42 between the housing base 8 and the PCB 14 may be prevented.

As further shown in Fig. 4, in one embodiment, the housing base 8 and the housing cover 10 may comprise welding sections 48, via which the housing base 8 and the housing cover 10 may be connected, e.g. by laser welding. At least one of the welding sections 48 may - according to yet another embodiment - be located at the engagement protrusion 42 of the housing base 8 or the housing cover 10. In the embodiment shown in Fig. 4, two welding sections 48 are located at the engagement protrusion 42 of the housing base 8.

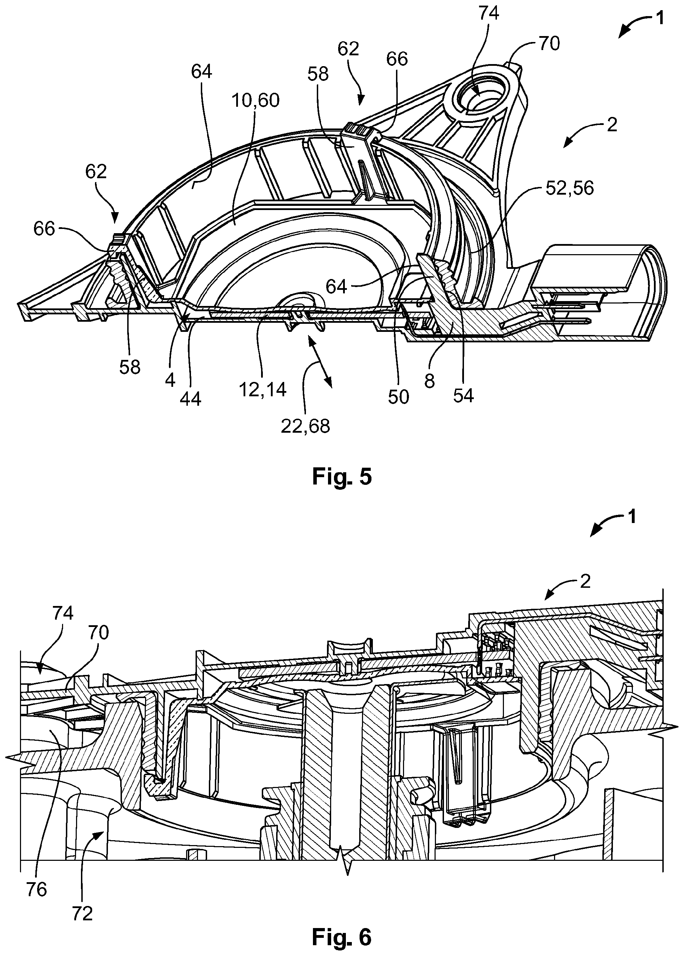

As best seen in Figs. 4 and 5, the housing base 8 may further comprise a collar 50 and a sealing element 52. In the shown embodiment, the collar 50 is substantially cylindrical and perpendicularly protrudes from the flat portion 44 of the housing base 8. The collar 50 may surround the receptacle 4 that may be formed between the flat portion 44 of the housing base 8 and the housing cover 10. The sealing element 52 may circumferentially extend around an outer side 54 of the collar 50, the outer side 54 of the collar 50 facing away from the receptacle 4 and the PCB 14 received in the receptacle 4. In Figs. 4 and 5, the sealing element 52 is provided as a sealing ring 56 concentrically surrounding the collar 50.

As shown in Figs. 4 and 5, the housing cover 10 may further comprise at least one holder 58. In the shown embodiment, the holders 58 perpendicularly protrude from a substantially flat portion 60 of the housing cover 10 and the holders 58 are monolithically formed with the housing cover 10. Each holder 58 may comprise a U-shaped section 62 away from the flat portion 60 of the housing cover 10. When the housing cover 10 is inserted into the collar 50 of the housing base 8, the holders 58 extend along an inner side 64 of the collar 50 and the U-shaped sections 62 surpass the collar 50 perpendicular to the pressing direction 22. In particular, the U-shaped sections 62 of the holders 58 may extend from the inner side 64 of the collar 50 to the outer side 54 of the collar 50. A leg 66 of the U-shaped sections 62 of the holders 58 may be located on the outer side 54 of the collar 50, being positioned next to the sealing element 52. Thereby, the sealing element 52 may be prevented from moving along a longitudinal axis 68 of the collar 50 and/or along the pressing direction 22, such that the sealing element 52 may be securely retained to the housing base 8.

As best seen in Figs. 5 and 6, the housing 2 of the mounting arrangement 1 may comprise mounting flanges 70, through which the mounting arrangement 1 may be connected to another device 72. Such a device 72 may, for example, correspond to another housing or housing arrangement. In the embodiment shown in Figs. 5 and 6, the mounting flanges 70 each are provided with a through-hole 74 adapted for engaging a complementary projection 76 of the device 72. In another embodiment, at least one through-hole 74 of the mounting flanges 70 may be threaded.

### Reference Signs

- 1: mounting arrangement
- 2: housing
- 4: receptacle
- 6: component fixation member
- 8: housing base
- 10: housing cover
- 12: electronic component
- 14: PCB
- 16: spring latch
- 18: base
- 20: free end
- 22: pressing direction
- 24: normal direction of the housing base
- 26: normal direction of the PCB
- 28: normal direction of the housing cover
- 30: mounted state
- 32: direction of deflection
- 34: restoring force
- 36: convex section
- 38: apex
- 40: O-ring
- 42: engagement protrusion
- 44: flat portion of the housing base
- 46: through-hole of the PCB
- 48: welding section
- 50: collar
- 52: sealing element
- 54: outer side of the collar
- 56: sealing ring
- 58: holder
- 60: flat portion of the housing cover
- 62: U-shaped section
- 64: inner side of the collar
- 66: leg of the U-shaped section
- 68: longitudinal axis of the collar
- 70: mounting flange
- 72: device
- 74: through-hole
- 76: projection

## Claims

1. A mounting arrangement (1) for holding an electronic component, comprising
a housing (2) having a housing base (8) and a housing cover (10) configured to be mounted onto the housing base (8),
a receptacle (4) for accommodating an electronic component (12), such as a PCB (14), between the housing base (8) and the mounted housing cover (8), and
at least one component fixation member (6) which is elastically deformable and configured to be located in the receptacle (4) for fixating the electronic component (12) in the receptacle (4).

2. A mounting arrangement (1) according to claim 1, wherein
a component fixation member (6) is monolithically formed with the housing base (8).

3. A mounting arrangement (1) according to claims 1 or 2, wherein
a component fixation member (6) is monolithically formed with the housing cover (10).

4. A mounting arrangement (1) according to any one of claims 1 to 3, wherein
a component fixation member (6) is formed as a spring latch (16) protruding towards the receptacle (4) at least partially.

5. A mounting arrangement (1) according to any one of claims 1 to 4, wherein
a component fixation member (6) comprises a convex section (36) protruding towards the receptacle (4).

6. A mounting arrangement (1) according to claim 1, wherein
a component fixation member (6) is an O-Ring (40).

7. A mounting arrangement (1) according to any one of claims 1 to 6, wherein
the mounting arrangement (1) comprises at least one component fixation member (6) of the group of component fixation members (6) comprising:
- a spring latch (16);
- a spring latch (16) being monolithically formed with the housing base (8);
- a spring latch (16) being monolithically formed with the housing cover (10);
- a component fixation member (6) comprising a convex section (36);
- a component fixation member (6) comprising a convex section (36), the component fixation member (6) being monolithically formed with the housing base (8);
- a component fixation member (6) comprising a convex section (36), the component fixation member (6) being monolithically formed with the housing cover (10);
- an O-ring (40).

8. A mounting arrangement (1) according to any one of claims 1 to 7, wherein
the housing base (8) and/or the housing cover (10) comprises at least one engagement protrusion (42) at least partially penetrating the receptacle (4).

9. A mounting arrangement (1) according to any one of claims 1 to 8, wherein
the housing base (8) and the housing cover (10) are joined by laser welding in at least one welding section (48).

10. A mounting arrangement (1) according to claim 9, wherein
a welding section (48) is located at an engagement protrusion (42).

11. A mounting arrangement (1) according to any one of claims 1 to 10, wherein
the housing base (8) comprises a collar (50) surrounding the receptacle (4), and
a sealing element (52) is provided, the sealing element (52) extending around an outer side (54) of the collar (50), the outer side (54) facing away from the receptacle (4).

12. A mounting arrangement (1) according to claim 11, wherein
the housing cover (10) comprises at least one holder (58) adapted for holding the sealing element (52) in position, wherein
the at least one holder (58) surpasses the collar perpendicular to the pressing direction (22).

13. A mounting arrangement (1) according to claim 12, wherein
a holder (58) is monolithically formed with the housing cover (10).

14. A mounting arrangement (1) according to any one of claims 1 to 13, wherein
the housing (2) comprises at least one mounting flange (70) via which the mounting arrangement (1) is connectable to another device (72).
